# EUROPEAN PATENT SPECIFICATION

(11) **EP 0 253 375 B1**
(45) Date of publication and mention of the grant of the patent: **03.02.1993**
(21) Application number: 87110218.2
(22) Date of filing: 15.07.1987
(51) Int. Cl.: H01L 41/08

(54) **Two-dimensional piezoelectric actuator**
Zweidimensionales piezoelektrisches Antriebsystem
Organe d'actionnement piézo-électrique bidimentionnel

(30) Priority: 15.07.1986 JP 165848/86; 04.03.1987 JP 49296/87
(43) Date of publication of application: 20.01.1988
(73) Proprietor: MATSUSHITA ELECTRIC INDUSTRIAL CO., LTD., Kadoma-shi, Osaka-fu, 571 (JP)
(72) Inventor: Fukada, Tetsuji, Suita-shi (JP); Wakamiya, Masayuki, Suita-shi (JP); Yamashita, Ichiro, Tsukuba-gun Ibaraki-ken (JP)
(74) Representative: Patentanwälte Leinweber & Zimmermann

(56) References cited:
- US-A- 4 520 570
- J. APPL. PHYS., vol. 59, no. 10, 15th May 1986, pages 3318-3327, American Institute of Physics; U. DÜRIG et al.: "Near-field optical-scanning microscopy"
- REVIEW OF SCIENTIFIC INSTRUMENTS, vol. 58, no. 4, April 1987, pages 567-570, American Institute of Physics, New York, NY, US; J.R. MATEY et al.: "Bimorph-driven x-y-z translation stage for scanned image microscopy"

## Description

### BACKGROUND OF THE INVENTION

### FIELD OF THE INVENTION

This invention relates to a two-dimensional piezoelectric micro-displacement unit for accurate positioning in the desired direction on the same surface. This apparatus may find applications for positioning of a color solid-state image sensor for the video camera, a displacer for high-resolution solid-state image sensor, a precision pattern positioning device and the like.

### DESCRIPTION OF THE RELATED ART

In conventional methods of positioning by micro displacement in the order of microns or submicrons, mechanical means such as a stepping motor or a DC servo motor has been used for converting rotational motion into linear motion by a ball-type screw. The conventional mechanical apparatus has necessarily some errors due to mechanical connections and is therefore apt to be large in size in order to improve the precision thereof.

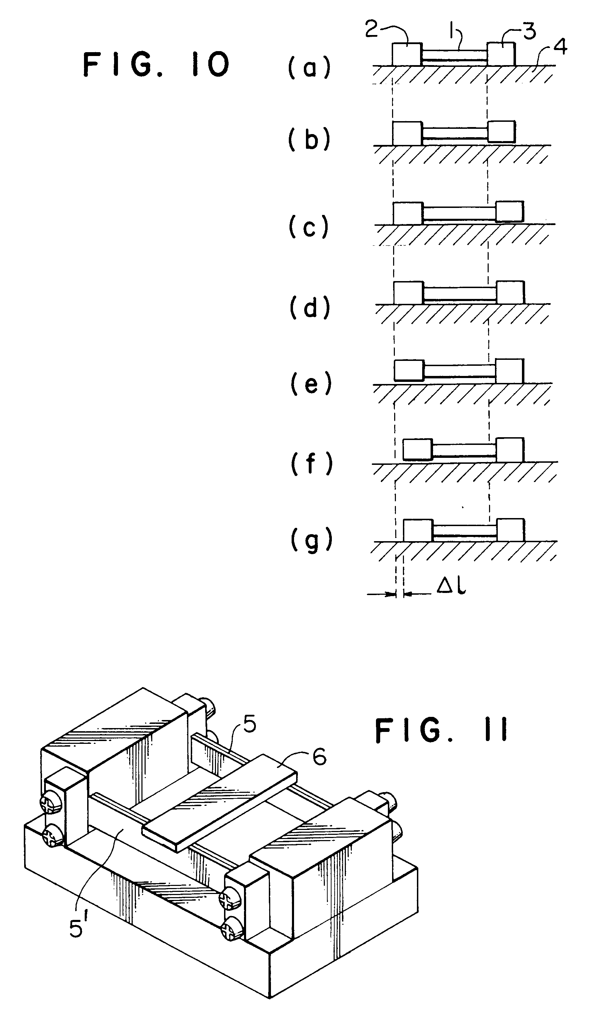

Then, a micro displacer using the reverse piezoelectric effect of a piezoelectric element capable of electrical control has been suggested. Such a displacer has a looper-type carriage mechanism as disclosed in the Japanese Patent Publication No. 12497/76. Fig. 10 is a diagram for explaining such a looper-type carriage mechanism having clamps 2, 3 operated by use of electrostatic or electromagnetic force at the ends of a cylindrical piezoelectric element 1. In Fig. 10(a), the clamps 2, 3 are clamped on a fixing table 4, and the clamp 3 is set free in Fig. 10(b). In Fig. 10(c), a voltage is applied to the piezoelectric element 1 to extend the same. In Fig. 10(d), the extended clamp 3 is clamped on the fixing table 4, and the clamp 2 is set free in Fig. 10(e). In Fig. 10(f), the applied voltage is removed, and in Fig. 10(g), the clamp 2 is clamped again. In this way, the same condition as in Fig. 10(a) is achieved, thus obtaining a displacement of Δℓ. A bilateral micro displacer is easily produced by mounting a similar carriage mechanism in two directions. The distortion caused by the reverse piezoelectric effect is so small that a highly accurate positioning is possible.

The Japanese Patent Laid-Open Publication No. 130677/83 and 196773/83, on the other hand, disclose a displacer for solid-state image sensor comprising a bending mode vibrator (bi-morph vibrator) with an end or both ends thereof fixed including a strip of piezoelectric elements attached on the upper and lower surfaces of a similarly-shaped thin metal plate, the piezoelectric element having a polarization axis along the thickness thereof, thus displacing the solid-state image sensor to increase the light-receiving area for a higher resolution. Fig. 11 shows a unilateral micro displacer using an example of such a bending mode vibrator. Bending mode vibrators 5, 5' with the ends thereof fixed are arranged in parallel to each other, and a carriage 6 having a solid-state image sensor or the like thereon is disposed at the central position of the bending mode vibrators 5, 5' where the amount of displacement is maximum.

A bilateral micro displacer is easily conceivable by mounting the above-mentioned looper-type micro displacer in two directions on the same surface. In view of the fact that one of the drive units is required to be clamped by electrostatic or electromagnetic force, however, an apparatus which is portable or used by being inclined is complicated in construction requiring separate means for fixing movable members while not in operation, resulting in a bulky apparatus. Also, the weight of movable objects while moving are concentrated at the part of the apparatus unclamped thereby to make the apparatus unstable. Further, the direction of motion is determined solely by the manner in which the apparatus is mounted, but the motion in the desired direction is impossible once the apparatus is mounted.

In a micro displacer using a bending mode vibrator, in spite of a large displacement allowable, the force generated is so weak that a heavy item cannot be moved. Also, under a heavy load, the resonant frequency of the vibrator is reduced, and the apparatus is rendered more liable to resonate to harmonic frequencies component of the drive frequency, thereby posing the problem of reduced durability. To obviate this problem by making micro displacement in the desired direction possible, a displacer (first displacement unit) with the bending mode vibrator described above may be used to displace another displacer (second displacement unit). Since the weight of the second displacement unit is exerted on the first displacement unit, however, the effect of the weight of the second displacement unit is required to be reduced by enlarging the bending mode vibrator of the first displacement unit, thereby leading to a bulky apparatus on the one hand and posing the problem of shorter durability on the other.

From the US-A-4 520 570 is known a piezoelectric X-Y-positioner including two pairs of bimorphs located in opposition to one another, of which the bimorphs of the first pair are attached with their longitudinal centers by supports to a rigid frame. A second pair of bimorphs located in opposition to one another support at their longitudinal centers a carriage for attachement of a sample to be positioned in the X-Y-plane. The bimorphs of the second pair are connected to the bimorphs of the first pair by connectors having a square-shaped sectional area so that each two ends of a bimorph of the first and second pair are arranged orthogonally to one another such that, for a displacement in the X and Y directions, each of the bimorphs has to be bent in a double S-form, the lengthwise central part of each bimorph being in a plane parallel to the plane of the ends of the bimorphs. For bending the bimorphs into the double S-shape, each bimorph carries four independent electrodes on either side of which the electrodes at the ends are connected to voltages inverse to the voltages of the electrodes near the center of the bimorphs, which makes necessary a circuitry for the supplying voltages. Further, the two pairs of bimorphs are arranged in different planes with respect to the direction parallel to the width of the bimorphs.

Further, from J. APPL. PHYS., vol. 59, no. 10, 15th May 1986, pages 3318-3327, American Institute of Physics; are known piezoelectric bimorphs consisting of two thin sheets of piezoceramic material one of which expands, the other contracts upon application of a voltage, such that the bending amplitude is larger than that of a unstructured bimorph material. The bimorphs described in this document also are bended into a S-shape by splitting the electrodes.

### SUMMARY OF THE INVENTION

It is an object of the present invention to provide a two-dimensional piezoelectric micro-displacement unit which has a large scanning range, is simple in construction and has compact dimensions.

According to the present invention there is provided a two-dimensional piezoelectric micro-displacement unit comprising a plurality of piezoelectric bimorphs each including two tabular piezoelectric elements laminated to each other, said tabular piezoelectric elements having a polarization axis along the thickness direction thereof and the polarization axes of each two piezoelectric elements laminated to each other being parallel, and electrodes at the opposed surfaces thereof, a plurality of fixing members for fixedly supporting a pair of opposed located piezoelectric bimorphs at the central parts of the length thereof, and a carriage mounted on another pair of opposed located piezoelectric bimorph members, the bimorphs being connected at their lengthwise ends so that the other pair of bimorphs is supported by the one pair of bimorphs, wherein the tabular piezoelectric elements are laminated to each other on the opposing sides of a thin metal strip bent into a rectangular shape, the bent portions of the metal strip forming the connections of the bimorphs at the lengthwise ends thereof, and the pairs of piezoelectric bimorphs being configured in the same plane with respect to the rectangular shape formed by the thin metal strip.

As a result, a compact micro displacer with simplified construction is provided which is capable of independent micro displacements in two directions.

### BRIEF DESCRIPTION OF THE DRAWINGS

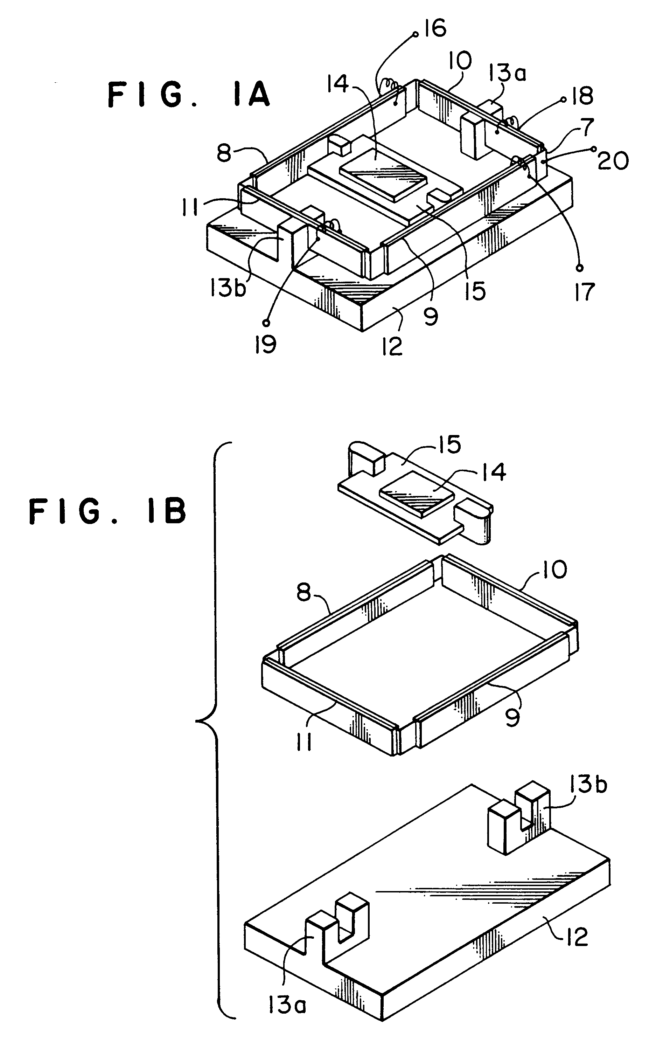

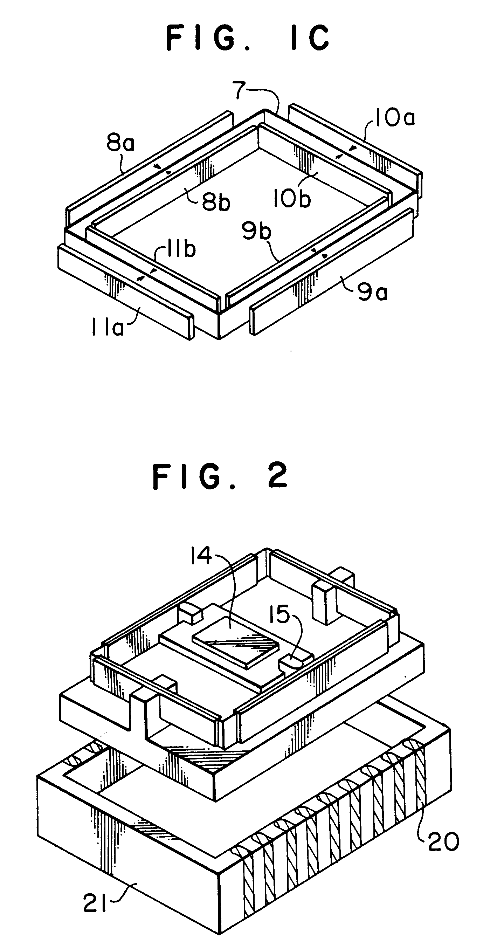

Figs. 1A, 1B, and 1C show a two-dimensional micro-displacement unit according to an embodiment of the present invention respectively, in which:
Fig. 1A is a perspective view, 1B an exploded perspective view, and 1C an exploded perspective view of the inventive micro-displacement unit.
Fig. 2 is an exploded perspective view of a two-dimensional micro-displacement unit in packaged form according to the present invention.
Figs. 3A and 3B, Fig. 4, Fig. 5, Fig. 6 and Fig. 7 show other embodiments of the present invention, in which Fig. 3A is a perspective view, Fig. 3B an exploded perspective view, Fig. 4, Fig. 5 and Fig. 6 exploded perspective views of a laminated piezoelectric bimorph element, and Fig. 7 an exploded perspective view of a micro-displacement unit.
Fig. 8 is an exploded perspective view of a laminated piezoelectric bimorph element.
Fig. 9A is a perspective view of a micro-displacement unit for a solid-state image sensor, and Fig. 9B an exploded perspective view thereof.
Fig. 10 and Fig. 11 are front view and perspective view of conventional micro-displacement units.

### DESCRIPTION OF THE PREFERRED EMBODIMENTS

Embodiments of the present invention will be explained in detail below with reference to the accompanying drawings.

Figs. 1A, 1B and 1C show an embodiment of the present invention, in which Fig. 1A is a perspective view, 1B an exploded perspective view, and 1C an exploded perspective view of a piezoelectric displacement unit. A rectangular thin metal strip 7 which is arranged in a rectangular form has vertically attached on the respective sides thereof tabular piezoelectric elements 8a, 8b; 9a, 9b; 10a, 10b; 11a, 11b with a polarization axis along the thickness directions and inner and outer electrodes. The tabular piezoelectric elements are so attached that the polarization axes thereof are arranged in the same direction, thereby constituting laminated piezoelectric bending of bimorph elements 8, 9, 10, 11 independent of each other. The central parts of the laminated piezoelectric bimorphs 10, 11 are fixedly supported by bonding or screwing with recessed fixing members 13a, 13b mountable to a base board 12, while the central parts of the piezoelectric bimorphs 8, 9 have mounted thereon a carriage 15 for carrying a movable member such as a solid-state image sensor 14. In order to assure conduction between the inner and outer electrodes of the laminated piezoelectric bimorphs 8, 9, 10, 11, voltage application terminals 16, 17, 18, 19 are provided, and the thin metal strip 7 is used as a common voltage application terminal 20. Upon application of a voltage to the voltage application terminals 20 and 16, 17, the laminated piezoelectric bimorphs 8, 9 function as both ends-supported bending elements and are displaced along the normal direction of the electrode surfaces. The amount of this displacement is proportional to the applied electric field and piezoelectric constant d31. Assume that the laminated piezoelectric elements 8a, 8b, 9a, 9b have the same thickness, and the polarization axes of the opposed laminated piezoelectric bimorphs 8, 9 are arranged in the same direction. Upon application of a voltage of the same phase, the laminated piezoelectric bimorphs 8, 9 are displaced in the same amount in the same direction, so that it is possible to displace the carriage mounted at the central parts thereof along the direction of displacement of the laminated piezoelectric bimorphs 8, 9, that is, along the normal direction of the electrode surfaces. The laminated piezoelectric bimorphs 10, 11, with the lengthwise central parts thereof fixedly supported by the fixing members 13a, 13b, on the other hand, function as a cantilever beam mode bending mechanism. When a voltage is applied to the terminals 20, 18, 19 in such a manner as to cause a displacement of the same amount in the same direction, the laminated piezoelectric bimorphs 8, 9 are displaced in the same direction, that is, along the normal direction against the electrode surfaces of the piezoelectric vibrators 10, 11, thus displacing the carriage 15 in the same direction. In view of the fact that the laminated piezoelectric bimorphs 8, 9 and 10, 11 can be driven independently of each other, the carriage 15 is displaceable in two directions on the same surface. Also, since the laminated piezoelectric bimorphs 8, 9, 10, 11 are constructed in the same plane, a compact micro-displacement unit capable of independent two-dimensional displacement simple in construction is provided. If conduction is assured with a grounding terminal between the voltage application terminals 16, 17, 18, 19 of the inner and outer electrodes of the laminated piezoelectric bimorphs and the fixing members, on the other hand, the resulting fact is that the thin metal strip 7 provides a common voltage application terminal 20, which reduces intrusion of noises while at the same time shorting by external contact is prevented.

The advantage of a reduced size leads to a great feature when the displacement unit is packaged with semiconductors in such applications as micro-displacement unit for a solid-state image sensor. Fig. 2 shows an example of such a package. A solid-state image sensor 14 is fixed on a carriage 15 of a two-dimensional micro-displacement unit by conductive adhesive or the like, and the displacement unit is fixedly mounted within a case 21 of ceramics or the like. The assembly is sealed in the case 21 with glass transparent to the light radiated on the light-receiving surface of the solid-state image sensor 14. The electric wiring to the piezoelectric elements required for two dimensional displacement and the solid-state image sensor are led out through electrodes 20 printed on the case 21.

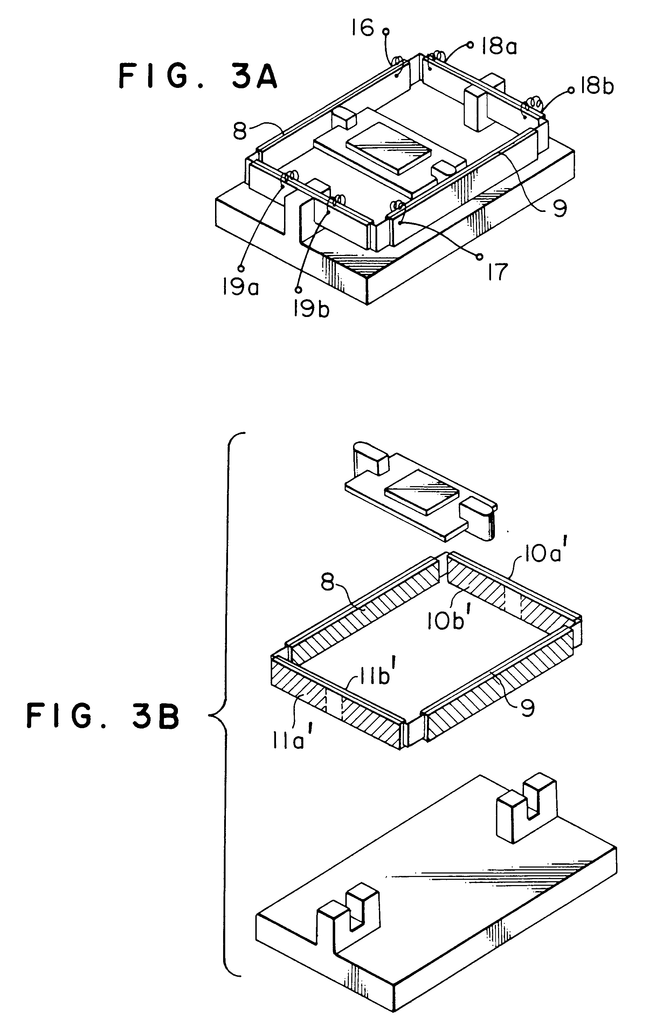

Now, another embodiment of the present invention will be described with reference to Figs. 3A and 3B. Fig. 3A is a perspective view and Fig. 3B an exploded perspective view. The inner and outer electrodes 10a', 10b'; 11a', 11b' of the piezoelectric bimorphs 10, 11 fixedly supported by fixing members at the central parts thereof are isolated at the central parts as shown by hatching in Fig. 3B. By applying a voltage between the such provided electrodes 18a, 18b, 19a, 19b and a common voltage application terminal 20, the cantilever beam mode bimorphs on the sides of the fixed parts are driven independently. Assume, for instance, that the laminated piezoelectric elements have the same thickness, and the opposed laminated piezoelectric bimorphs 10, 11 have the same direction of polarization axis. When a voltage of the same phase is applied to the voltage application terminals 20 and 18a, 19b, the laminated piezoelectric bimorph 8 is displaced, while by applying a voltage of the same phase to the voltage application terminals 20 and 18b, 19b in a similar manner, the laminated piezoelectric bimorph 9 is displaceable. Specifically, the laminated piezoelectric bimorphs 8 and 9 are displaced independently of each other. By applying different voltages to the voltage application terminals 18a, 19a and 18b, 19b, therefore, the amount of displacement of the laminated piezoelectric bimorphs 8, 9 are differentiated thereby to incline the carriage 15 in the horizontal plane. This leads to the feature that any inclination of the solid-state image sensor mounted on the base within the horizontal plane is correctable and the angle adjustable in such applications as precision micro positioning in mask matching of integrated circuits or the like.

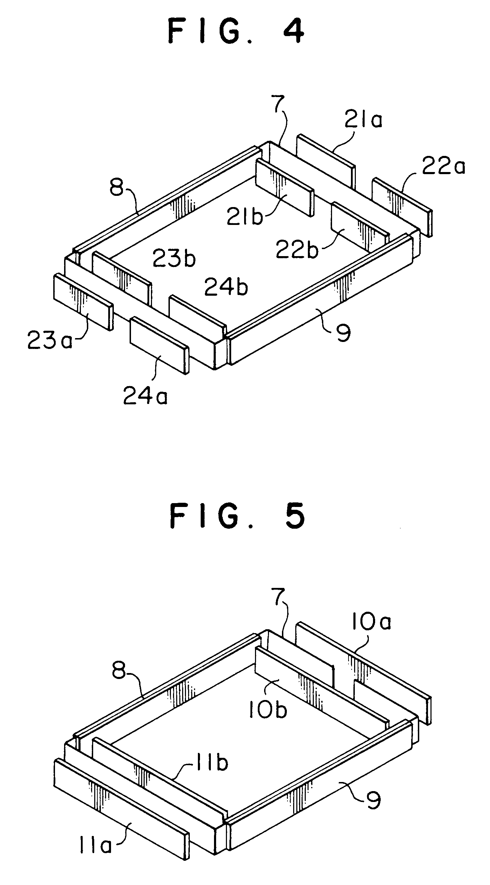

Fig. 4 is an exploded perspective view of laminated piezoelectric bimorphs according to still another embodiment of the present invention. Piezoelectric bimorphs with the central parts thereof fixedly supported by fixing members are constructed of tabular piezoelectric elements 21a, 21b; 22a, 22b; 23a, 23b; 24a, 24b applied vertically on the surfaces of the thin metal strip 7 in such a manner as to be separated at the central parts thereof. In this construction, the piezoelectric bimorphs on the sides on the fixing members are drivable independently, thereby resulting in the great advantage that an inclination can be corrected or micro positioning is made possible as described above.

Fig. 5 is an exploded perspective view of a laminated piezoelectric bimorphs according to a further embodiment of the present invention. A rectangular thin metal strip 7 is formed by bending a metal sheet, and is configured in such a manner that the ends of the thin metal strip 7 are located at the central parts of the piezoelectric elements 10a, 10b to be laminated. In view of the fact that the ends of the thin metal strip are positioned at the parts fixed by the fixing members, the amount of displacement as a piezoelectric bimorph is not affected, and also the fact that the rectangular thin metal strip can be obtained from a sheet of metal simplifies the construction easy to fabricate.

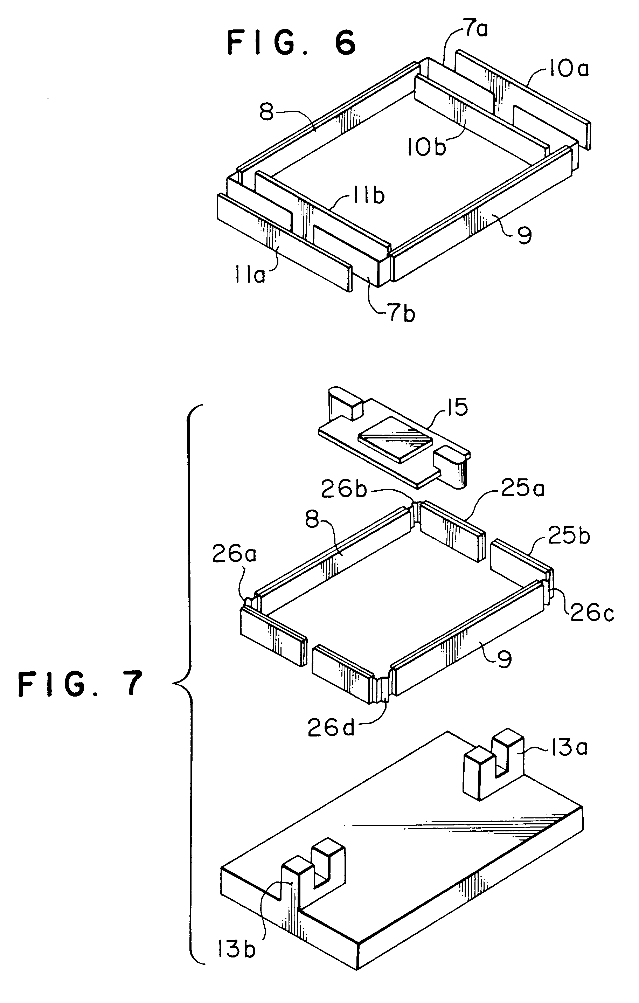

Fig. 6 is an exploded perspective view of a laminated piezoelectric unit according to a still further embodiment of the present invention. Rectangular thin metal strips 7a, 7b bent in channel shape or C-shape are opposed to each other thereby to make up a thin metal strip arrangement formed in rectangle with the ends of the strips 7a, 7b at the central parts of the piezoelectric elements 10a, 10b; 11a, 11b to be laminated. The thin metal strips 7a, 7b are fabricated by being bent only in one direction, thereby leading to a high mass production efficiency.

Fig. 7 is an exploded view of a micro-displacement unit according to another embodiment of the present invention. Micro-displacement units 25a, 25b with tabular piezoelectric elements attached vertically on the surfaces of rectangular thin metal strips 7a, 7b are bent in channel shape and arranged with the ends thereof opposed to each other. The ends of the micro-displacement units 25a, 25b are fixedly supported by fixing members 13a, 13b. Since this apparatus is constructed of fully independent micro displacement units, the great advantage results that the variations in the characteristics of the piezoelectric cantilever beam mode bimorphs are offset by adjusting the length of the fixed parts of the piezoelectric bimorphs at the time of mounting thereof by the fixing members.

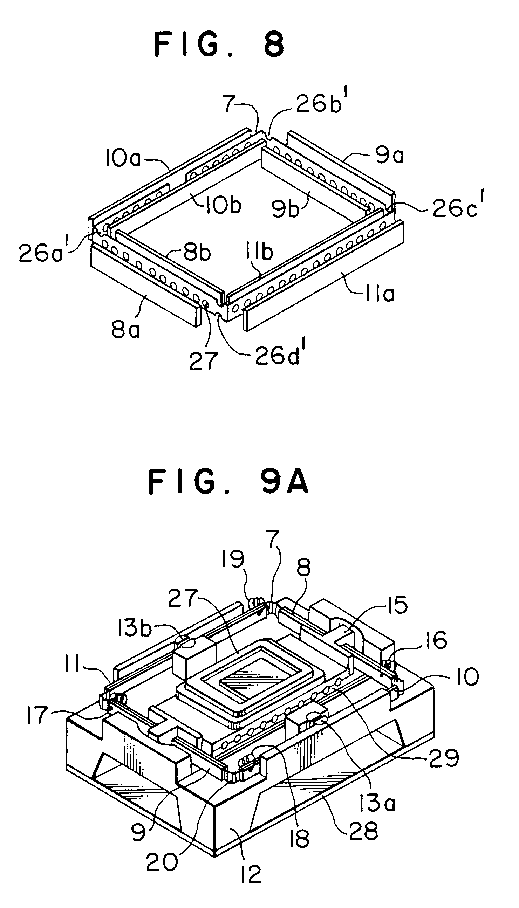

Fig. 8 is an exploded perspective view of a piezoelectric micro-displacement unit according to still another embodiment of the present invention. In view of the fact that a piezoelectric cantilever beam mode bimorph is coupled with a laminated both ends-supported bimorph thereof by a metal thin plate, they are affected by each other. Neverthless, the modulus of flexural rigidity of the thin metal strips on the sides of the laminated piezoelectric both ends-supported bimorph thereof supported is increased by forming U-shaped recesses 26a, 26b, 26c, 26d as shown in Fig. 7 or narrow parts 26a', 26b', 26c', 26d' as shown in Fig. 8. In this way, the reliability is improved with a reduced mutual effect. Further, if apertures 27 are formed in the thin metal strip, piezoelectric elements are bonded to each other at these parts thereby to improve the bonding strength between the metal and piezoelectric elements.

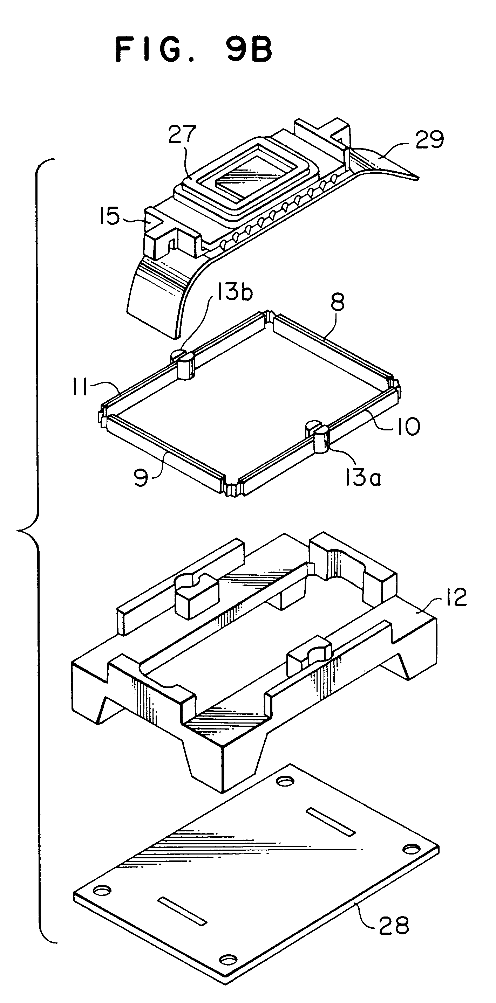

Figs. 9A and 9B are diagrams showing a micro-displacement unit for a solid-state image sensor according to another embodiment of the present invention. Fig. 9A is a perspective view of the apparatus, and Fig. 9B an exploded perspective view thereof. A solid-state image sensor device 27 is mounted on a carriage 15. Signals of the solid-state image sensor device 27 and signals applied to voltage application terminals 16, 17, 18, 19 of laminated piezoelectric bimorphs 8, 9, 10, 11 are connected to a flexible base board 29 for connection to a printed board 28 mounted on the bottom of the base board 12. This construction provides an apparatus capable of accurate adjustment of mounting positions and color matching for a given solid-state image sensor device.

It will thus be understood from the foregoing description that according to the present invention, there is provided a compact micro-displacement unit which is simple in construction and capable of independent displacement in two directions, comprising laminated piezoelectric bimorphs of cantilever type and laminated piezoelectric bimorphs with the ends thereof supported, both vibrators being configured in the same plane.

## Claims

1. A two-dimensional piezoelectric micro-displacement unit comprising a plurality of piezoelectric bimorphs (8,9, 10,11) each including two tabular piezoelectric elements (8a,8b;9a,9b;10a,10b;11a,11b) laminated to each other, said tabular piezoelectric elements (8a,8b;9a,9b;10a,10b;11a, 11b) having a polarization axis along the thickness direction thereof and the polarization axes of each two piezoelectric elements laminated to each other being parallel, and inner and outer electrodes (16,17,18,19) at the opposed surfaces thereof, a plurality of fixing members (13a,13b) for fixedly supporting a pair of opposed located piezoelectric bimorphs (10,11) at the central parts of the length thereof, and a carriage (15) mounted on another pair of opposed located piezoelectric bimorph members (8,9), the bimorphs (8,9,10,11) being connected at their lengthwise ends so that the other pair of bimorphs (8,9) is supported by the one pair of bimorphs (10,11), **characterized in that** the tabular piezoelectric elements (8a,8b;9a,9b;10a,10b; 11a,11b) are laminated to each other on the opposing sides of a thin metal strip (7) bent into a rectangular shape, the bent portions of the metal strip (7) forming the connections of the bimorphs at the lengthwise ends thereof, and the pairs of piezoelectric bimorphs (8,9;10,11) being configured in the same plane with respect to the rectangular shape formed by the thin metal strip (7).

2. A two-dimensional piezoelectric micro-displacement unit according to claim 1, wherein the inner and outer electrodes (16,17,18,19) of said laminated piezoelectric bimorphs provide independent voltage application terminals (16,17,18,19), and said thin metal strip (7) provides a common voltage application terminal (20) for all the laminated piezoelectric bimorphs.

3. A two-dimensional piezoelectric micro-displacement unit according to claim 1 or 2, wherein the inner and outer electrodes of the laminated piezoelectric bimorphs (10,11) fixedly supported by fixing members (13a,13b) are isolated at the central parts thereof for independent voltage application.

4. A two-dimensional piezoelectric micro-displacement unit according to anyone of claims 1 to 3, wherein the tabular piezoelectric elements (10a,10b;11a,11b) of the pair of the piezoelectric bimorphs (10,11) fixedly supported at the central parts thereof by fixing members (13a,13b) are isolated at the fixed parts thereof.

5. A two-dimensional piezoelectric micro-displacement unit according to anyone of claims 1 to 4, wherein the ends of said thin metal strip (7) are coincident with the fixed central parts of the laminated piezoelectric bimorphs (10, 11) fixedly supported by the fixing members (13a,13b).

6. A two-dimensional piezoelectric micro-displacement unit according to anyone of claim 1 to 4, wherein two C-shaped strips of thin metal (7a,7b) are formed into a rectangular form, the ends of said two thin metal strips (7a,7b) being coincident with the central fixed parts of the laminated piezoelectric bimorphs (8,9) fixedly supported by fixing members (13a,13b).

7. A two-dimensional piezoelectric micro-displacement unit according to anyone of claims 1 to 4, comprising two micro displacement arrangements (25a,25b) each including tabular piezoelectric elements attached to the inner and outer surfaces of a thin strip of metal bent into a C-shape, said micro displacement arrangements (25a,25b) being arranged with the ends thereof opposed to each other, said ends being fixedly supported by fixing members (13a,13b).

8. A two-dimensional piezoelectric micro-displacement unit according to anyone of claims 1 to 7, wherein a plurality of apertures (27) are formed into the thin strip of metal.

9. A two-dimensional piezoelectric micro-displacement unit according to anyone of claims 1 to 8, wherein the modulus of flexural rigidity of the thin metal strip (7) at the ends of the laminated piezoelectric vibrators (8,9) having the carriage (15) mounted thereon is increased by an U-shaped form (26a-26d) or narrow parts (26a'-26d').

10. A two-dimensional piezoelectric micro-displacement unit according to anyone of claims 1 to 9, wherein the carriage (15) has mounted thereon a solid-state image sensor (14).

11. A two-dimensional piezoelectric micro-displacement unit according to claim 10, comprising a flexible base board (12) wherein signals of the solid-state image sensor (14) mounted on the carriage (15) are processed externally and the voltage application signals applied to the laminated piezoelectric bimorphs (8,9,10,11) are produced externally.

## Patentansprüche

1. Zweidimensionale piezoelektrische Mikroverschiebungseinheit mit einer Anzahl von jeweils zwei aneinander laminierte tafelförmige piezoelektrische Elemente (8a,8b; 9a,9b;10a,10b;11a,11b) enthaltenden piezoelektrischen Zweikristallelementen (8,9,10,11), wobei die tafelförmigen piezoelektrischen Elemente (8a,8b;9a,9b;10a,10b;11a,11b) eine Polarisationsachse längs der Richtung ihrer Dicke aufweisen und die Polarisationsachsen von jeweils zwei aneinander laminierten piezoelektrischen Elementen parallel sind, sowie mit inneren und äußeren Elektroden (16,17,18,19) an deren gegenüberliegenden Oberflächen, einer Anzahl von Befestigungselementen (13a,13b) zur festen Halterung eines Paars von gegenüberliegend angeordneten piezoelektrischen Zweikristallelementen (10,11) an den mittleren Bereichen von deren Länge, und einem an einem weiteren Paar von gegenüberliegend angeordneten piezoelektrischen Zweikristallelementen (8,9) angeordneten Schlitten (15), wobei die Zweikristallelemente (8,9,10,11) an ihren längsweisen Enden so verbunden sind, daß das weitere Paar von Zweikristallelementen (8,9) von dem einen Paar von Zweikristallelementen (10,11) getragen ist, **dadurch gekennzeichnet,** daß die tafelförmigen piezoelektrischen Elemente (8a,8b;9a,9b; 10a,10b;11a,11b) an den gegenüberliegenden Seiten eines in eine rechteckige Form gebogenen dünnen Metallstreifens (7) aneinander laminiert sind, wobei die gebogenen Bereiche des Metallstreifens (7) die Verbindungen der Zweikristallelemente an deren längsweisen Enden bilden und die Paare von piezoelektrischen Zweikristallelementen (8,9;10,11) in der gleichen Ebene bezüglich der durch den dünnen Metallstreifen (7) gebildeten rechteckigen Form konfiguriert sind.

2. Zweidimensionale piezoelektrische Mikroverschiebungseinheit nach Anspruch 1, bei der die inneren und äußeren Elektroden (16,17,18,19) der laminierten piezoelektrischen Zweikristallelemente unabhängige Spannungszuführungsanschlüsse (16,17,18,19) bilden, und der dünne Metallstreifen (7) einen gemeinsamen Spannungszuführungsanschluß (20) für alle laminierten piezoelektrischen Zweikristallelemente bildet.

3. Zweidimensionale piezoelektrische Mikroverschiebungseinheit nach Anspruch 1 oder 2, bei der die inneren und äußeren Elektroden der von den Befestigungselementen (13a,13b) fest gehalterten laminierten piezoelektrischen Zweikristallelemente (10,11) für eine unabhängige Spannungszuführung an deren mittleren Bereichen isoliert sind.

4. Zweidimensionale piezoelektrische Mikroverschiebungseinheit nach einem der Ansprüche 1 bis 3, bei der die tafelförmigen piezoelektrischen Elemente (10a,10b;11a,11b) des Paars von durch Befestigungselemente (13a,13b) an deren mittleren Bereichen fest gehalterten piezoelektrischen Zweikristallelementen (10,11) an deren festgelegten Bereichen isoliert sind.

5. Zweidimensionale piezoelektrische Mikroverschiebungseinheit nach einem der Ansprüche 1 bis 4, bei der sich die Enden des dünnen Metallstreifens (7) mit den festgelegten mittleren Bereichen der von den Befestigungselementen (13a,13b) fest gehalterten laminierten piezoelektrischen Zweikristallelemente (10,11) in Übereinstimmung befinden.

6. Zweidimensionale piezoelektrische Mikroverschiebungseinheit nach einem der Ansprüche 1 bis 4, bei der zwei C-förmige Streifen aus dünnem Metall (7a,7b) in eine rechteckige Form gebracht sind, wobei sich die Enden der beiden dünnen Metallstreifen (7a,7b) mit den mittleren festgelegten Bereichen der durch Befestigungselemente (13a,13b) fest gehalterten laminierten piezoelektrischen Zweikristallelemente (8,9) in Übereinstimmung befinden.

7. Zweidimensionale piezoelektrische Mikroverschiebungseinheit nach einem der Ansprüche 1 bis 4, enthaltend zwei jeweils an den inneren und äußeren Oberflächen eines dünnen in eine C-Form gebogenen Metallstreifens befestigte tafelförmige piezoelektrische Zweikristallelemente umfassende Mikroverschiebungsanordnungen (25a,25b), wobei die Mikroverschiebungseinheiten (25a,25b) mit ihren Enden einander gegenüberliegend angeordnet sind, wobei die Enden durch Befestigungselemente (13a,13b) fest gehaltert sind.

8. Zweidimensionale piezoelektrische Mikroverschiebungseinheit nach einem der Ansprüche 1 bis 7, bei der in dem dünnen Metallstreifen eine Anzahl von Öffnungen (27) ausgebildet sind.

9. Zweidimensionale piezoelektrische Mikroverschiebungseinheit nach einem der Ansprüche 1 bis 8, bei der das Biegesteifigkeitsmodul des dünnen Metallstreifens (7) an den Enden der den daran angebrachten Schlitten (15) aufweisenden laminierten piezoelektrischen Schwingelemente (8,9) durch eine U-förmige Gestalt (26a-26d) oder schmale Teile (26a'-26d') erhöht ist.

10. Zweidimensionale piezoelektrische Mikroverschiebungseinheit nach einem der Ansprüche 1 bis 9, bei der der Schlitten (15) einen darauf angebrachten Festkörperbildsensor (14) aufweist.

11. Zweidimensionale piezoelektrische Mikroverschiebungseinheit nach Anspruch 10, enthaltend eine flexible Basisplatte (12), wobei Signale des auf dem Schlitten (15) angebrachten Festkörperbildsensors (14) extern verarbeitet und die an die laminierten piezoelektrischen Zweikristallelemente (8,9,10,11) angelegten Spannungszuführungssignale extern erzeugt werden.

## Revendications

1. Unité de micro-déplacement bidimensionnel par effet piézo-électrique, comprenant plusieurs dimorphes piézo-électriques (8, 9, 10, 11) qui comportent chacun deux éléments piézo-électriques (8a, 8b; 9a, 9b; 10a, 10b; 11a, 11b) en forme de lamelle, unis en un stratifié, lesdits éléments piézo-électriques en lamelle (8a, 8b; 9a, 9b; 10a, 10b; 11a, 11b) ayant un axe de polarisation dans la direction de leur épaisseur et les axes de polarisation de chaque paire d'éléments piézo-électriques unis en un stratifié étant parallèles, ainsi que des électrodes internes et externes (16, 17, 18, 19) sur leurs surfaces opposées, plusieurs éléments de fixation (13a, 13b) pour supporter en position fixe une paire de dimorphes piézo-électriques (10, 11) situés en face l'un de l'autre, au niveau de la partie médiane de leur longueur, et un chariot (15) monté sur une autre paire de dimorphes piézo-électriques (8, 9) situés en face l'un de l'autre, les dimorphes (8, 9, 10, 11) étant connectés par leurs extrémités longitudinales de sorte que ladite autre paire de dimorphes (8, 9) soit supportée par la première paire de dimorphes (10, 11), caractérisée en ce que les éléments piézo-électriques en lamelle (8a, 8b; 9a, 9b; 10a, 10b; 11a, 11b) sont unis en un stratifié sur les faces opposées d'une bande mince de métal (7) coudée en un cadre de forme rectangulaire, les parties coudées de la bande de métal (7) formant les connexions des dimorphes à leurs extrémités longitudinales, et les paires de dimorphes piézo-électriques (8, 9; 10, 11) étant formées dans le même plan par rapport au cadre de forme rectangulaire constitué par la bande mince de métal (7).

2. Unité de micro-déplacement bidimensionnel par effet piézo-électrique selon la revendication 1, dans laquelle les électrodes internes et externes (16, 17, 18, 19) desdits dimorphes piézo-électriques stratifiés constituent des bornes indépendantes d'application de tension (16, 17, 18, 19), et en ce que ladite bande mince de métal (7) constitue une borne commune d'application de tension (20) pour tous les dimorphes piézo-électriques stratifiés.

3. Unité de micro-déplacement bidimensionnel par effet piézo-électrique selon la revendication 1 ou 2, dans laquelle les électrodes internes et externes des dimorphes piézo-électriques stratifiés (10, 11) qui sont supportés en position fixe par les éléments de fixation (13a, 13b) sont isolées dans la partie médiane de ces dimorphes, pour une application indépendante de tension.

4. Unité de micro-déplacement bidimensionnel par effet piézo-électrique selon l'une quelconque des revendications 1 à 3, dans laquelle les éléments piézo-électriques en lamelle (10a, 10b; 11a, 11b) de la paire de dimorphes piézo-électriques (10, 11) qui sont supportés en position fixe au niveau de leur partie médiane par des éléments de fixation (13a, 13b) sont isolés au niveau de leurs parties fixées.

5. Unité de micro-déplacement bidimensionnel par effet piézo-électrique selon l'une quelconque des revendications 1 à 4, dans laquelle les extrémités de ladite bande mince de métal (7) coïncident avec les parties médianes fixées des dimorphes piézo-électriques stratifiés (10, 11) supportés en position fixe par les éléments de fixation (13a, 13b).

6. Unité de micro-déplacement bidimensionnel par effet piézo-électrique selon l'une quelconque des revendications 1 à 4, dans laquelle deux bandes de métal mince en forme de C (7a, 7b) sont mises sous forme de cadre rectangulaire, les extrémités de ces deux bandes de métal mince (7a, 7b) coïncidant avec les parties médianes fixées des dimorphes piézo-électriques stratifiés (8, 9) qui sont supportés en position fixe par les éléments de fixation (13a, 13b).

7. Unité de micro-déplacement bidimensionnel par effet piézo-électrique selon l'une quelconque des revendications 1 à 4, comprenant deux dispositifs de micro-déplacement (25a, 25b) comportant chacun des éléments piézo-électriques en lamelle fixés sur les surfaces interne et externe d'une bande mince de métal coudée en forme de C, ces dispositifs de micro-déplacement (25a, 25b) étant disposés de sorte que leurs extrémités soient mutuellement opposées, ces extrémités étant supportées en position fixe par des éléments de fixation (13a, 13b).

8. Unité de micro-déplacement bidimensionnel par effet piézo-électrique selon l'une quelconque des revendications 1 à 7, dans laquelle une multiplicité d'ouvertures (27) est formée dans la bande mince de métal.

9. Unité de micro-déplacement bidimensionnel par effet piézo-électrique selon l'une quelconque des revendications 1 à 8, dans laquelle le module de rigidité à la flexion de la bande mince de métal (7) est augmenté, aux extrémités des vibreurs piézo-électriques stratifiés (8, 9) sur lesquels est monté le chariot (15), par un profil en U (26a-26d) ou par des parties étroites (26a'-26d').

10. Unité de micro-déplacement bidimensionnel par effet piézo-électrique selon l'une quelconque des revendications 1 à 9, dans laquelle un détecteur d'images à semiconducteurs (14) est monté sur le chariot (15).

11. Unité de micro-déplacement bidimensionnel par effet piézo-électrique selon la revendication 10, comprenant une plaque de base flexible (12) et dans laquelle les signaux du détecteur d'images à semiconducteurs (14) monté sur le chariot (15) sont traités extérieurement et les signaux d'application de tension appliqués aux dimorphes piézo-électriques stratifiés (8, 9, 10, 11) sont produits extérieurement.
